# EUROPÄISCHE PATENTSCHRIFT

(11) **EP 2 789 098 B1**
(45) Veröffentlichungstag und Bekanntmachung des Hinweises auf die Patenterteilung: **29.04.2020**
(21) Anmeldenummer: 12812182.9
(22) Anmeldetag: 29.11.2012
(51) Int. Cl.: H03H 9/145, H03H 9/02

(54) **AKUSTISCHES OBERFLÄCHENWELLENBAUELEMENT UND VERFAHREN ZU SEINER HERSTELLUNG**
SURFACE ACOUSTIC WAVE COMPONENT AND METHOD FOR PRODUCING IT
ÉLÉMENT À ONDES ACOUSTIQUES DE SURFACE ET PROCÉDÉ DE FABRICATION CORRESPONDANT

(30) Priorität: 06.12.2011 DE 102011087820
(43) Veröffentlichungstag der Anmeldung: 15.10.2014
(60) Teilanmeldung: 17166254.7
(73) Patentinhaber: Leibniz-Institut für Festkörper- und Werkstoffforschung Dresden e.V., 01069 Dresden (DE)
(72) Erfinder: MENZEL, Siegfried, 04924 Lausitz (DE); WINKLER, Andreas, 01069 Dresden (DE)
(74) Vertreter: Rauschenbach, Marion
(86) Internationale Anmeldenummer: PCT/EP2012/073933
(87) Internationale Veröffentlichungsnummer: WO 2013/083469

(56) Entgegenhaltungen:
- EP-A2- 1 467 484
- DE-A1- 10 320 702
- DE-A1-102007 012 384
- JP-A- 2005 012 736
- US-A1- 2004 233 020
- US-B1- 7 053 523

## Beschreibung

Die Erfindung bezieht sich auf das Gebiet der Elektrotechnik/Akustoelektronik und betrifft ein akustisches Oberflächenwellen(surface acoustic wave, SAW)-Bauelement, wie es beispielsweise als Filterbauelement in mobilen Telefonen, als Sensor oder als Aktor zum Einsatz kommen kann, und ein Verfahren zu seiner Herstellung.

Die SAW-Technologie hat in den letzten Jahren eine breite Anwendung gefunden. Da im Vergleich zu elektromagnetischen Wellen die Wellenlänge akustischer Oberflächenwellen um mehrere Größenordnungen kürzer ist (ca. Faktor 10⁵ bei vergleichbarer Frequenz), kann die SAW-Technologie insbesondere vorteilhaft zur Miniaturisierung von Bauelementen, Baugruppen oder Geräten eingesetzt werden. Dies betrifft insbesondere Hochfrequenzfilter (SAW-Filter) für mobile Telefone, sowie Sensoren oder Aktoren. Ein großer Vorteil von SAW-Bauelementen im Vergleich zu elektronischen Halbleiterbauelementen besteht u.a. auch darin, dass bei Verwendung von temperaturbeständigen Materialien ein wesentlich größerer Einsatztemperaturbereich (bis über 900°C) abgedeckt werden kann (R.C. Turnera, et al: Applied Acoustics Vol. 41, 4 (1994) 299-324; M.N. Hamidon, et al: Sensors and Actuators A 123-124 (2005) 403-407). Für Anwendungen in komplexen elektronischen Schaltungen oder Netzwerken sollen SAW-Bauelemente generell eine geringe Einfügedämpfung, eine hohe Güte und Zuverlässigkeit, sowie insbesondere eine hohe Leistungsbeständigkeit und Lebensdauer aufweisen.

Zwei bekannte Beispiele für SAW-Bauelemente sind die Verzögerungsstrecke und der Resonator. Nachfolgend wird anhand einer Verzögerungsstrecke die Wirkungsweise der SAW-Bauelemente erläutert. Eine Verzögerungsstrecke besteht aus zwei voneinander getrennt angeordneten Interdigitalwandlern (Interdigital Transducer, IDT). Ein IDT ist eine Anordnung kammförmig ineinander greifender Metallstreifen (Fingerelektroden), die mit Hilfe von Strukturierungsverfahren in Planartechnologie (z.B. Nass- oder Trockenätzverfahren oder Lift-Off-Technik) hergestellt werden. Die Fingerelektroden eines jeden IDT sind alternierend elektrisch über Verbindungsleitungen (bus-bars) mit jeweils einer Kontaktfläche (Pad) verbunden. Der Bereich, in dem die kammförmigen Fingerelektroden ineinander greifen, wird Apertur genannt. Durch Anlegen einer elektrischen Wechselspannung (meist hochfrequente Spannung, HF-Spannung) an die beiden Kontaktflächen des einen IDT (Eingangswandler) wird zwischen den jeweils benachbarten Fingerelektroden ein elektrisches Feld erzeugt. Über den inversen piezoelektrischen Effekt wird das Substratmaterial zwischen den Elektroden in den Halbperioden abwechselnd gestaucht bzw. gestreckt, wodurch eine akustische (mechanische) Welle an der Substratoberfläche nach beiden Seiten des Eingangswandlers ausgesandt wird. Bei entsprechender Winkelausrichtung des IDT auf dem Piezosubstrat, d.h. bei Anordnung der Längsachse der Fingerelektroden senkrecht zu der an der Substratoberfläche liegenden maximalen Geschwindigkeitskomponente des Substrates (SAW-Ausbreitungsrichtung), wird die akustische Welle vornehmlich entlang der Substratoberfläche (Surface Acoustic Wave, SAW) und senkrecht zu den beiden Seiten der Fingerelektroden abgestrahlt. Da die SAW ihrerseits aufgrund des piezoelektrischen Effektes ein elektrisches Feld mitführt, kann dieses elektrische Feld von einem zweiten IDT (Ausgangswandler) über den piezoelektrischen Effekt wieder in eine elektrische Spannung umgewandelt werden. Dieser Prozess der Umwandlung von mechanischer in elektrische Energie und umgekehrt ist umso effizienter, je besser die Maßhaltigkeit der Elektrodenfingeranordnung ist und damit - aufgrund der Gültigkeit der Wellengesetze - die Bedingungen für eine konstruktive Überlagerung (im Gegensatz zur destruktiven Überlagerung oder Auslöschung) der von den einzelnen Fingerpaaren erzeugten Teilwellen gegeben sind. Im einfachsten und am häufigsten verwendeten Fall entspricht der Mittenabstand benachbarter Fingerelektroden unterschiedlichen elektrischen Potenzials der halbe Wellenlänge (λ/2) und die Breite der Elektroden sowie der Zwischenräume zwischen den Elektroden einem Viertel der Wellenlänge (λ/4).

Die so gestalteten IDT sind in bekannten SAW-Bauelementen direkt mit der Oberfläche des piezoelektrischen Substratmaterials verbunden. Als piezoelektrisches Substrat werden dabei meist Einkristallwafer mit einem bestimmten Kristallschnitt oder piezoelektrische Schichten auf einem Trägermaterial (z.B. oxidierter Si-Wafer) verwendet. Infolge der direkten Abscheidung des Elektrodenmaterials als leitfähige Dünnschicht auf das meist vorbehandelte und mit einer dünnen Haftvermittlerschicht versehene piezoelektrische Substrat haften diese Schichten auf dessen Oberfläche über einen physikalischen oder chemischen Zusammenhalt von piezoelektrischem Substrat und Metallschicht (mechanische und spezifische Adhäsion, physikalische oder chemische Adsorption) (K. L. Mittal: Electrocomponent Science and Technology, 1976, Vol. 3, pp. 21-42).

Bei den bekannten SAW-Technologien ist eine gute Haftung zwischen piezoelektrischem Substrat und Metallschicht von großem Vorteil für die Fixierung der Fingeranordnung an der Substratoberfläche und für die effiziente Einkopplung des elektrischen Feldes in das Substrat. Andererseits bewirkt sie jedoch bekanntermaßen eine vollständige Übertragung der durch die SAW generierten, zeitabhängigen lokalen Dehnung (Wechsel aus Druck- und Zugbelastung) der Substratoberfläche (F. Kubat: Theoretische und experimentelle Untersuchungen zur Leistungsfähigkeit von Oberflächenwellen-Filtern, Dissertation Albert-Ludwigs-Universität Freiburg, Freiburg 2004). Die damit verbundene, zeitlich veränderliche mechanische Spannungsverteilung in den Fingerelektroden kann infolge einer Kombination von Rissbildung (als Folge von Ermüdungseffekten) und Materialtransport (als Folge von Drift-Diffusion) bei hohen eingekoppelten Leistungen und folglich hohen SAW-Amplituden zur irreversiblen Degradation der Fingerelektroden (Mikrostrukturschädigung) und somit des elektrischen Signalverhaltens (z.B. irreversibler Frequenzshift eines Filterbauelements) bis zum Ausfall des SAW-Bauelements führen. Bei schlechter oder partiell schlechter Haftung der Fingerelektroden auf dem piezoelektrischen Substrat ist eine vollständige oder teilweise Delamination der Elektroden bis hin zu Abplatzungen infolge Mikrorissbildung möglich. Mikrorissbildung, Materialtransport (d.h. Loch- und Hügelbildung) und Delamination oder Abplatzungen zerstören die Mikrostruktur und die Geometrie der Fingeranordnung und somit das elektrische Signalverhalten des SAW-Bauelements.

Die Intensität der irreversiblen Degradation der SAW-Bauelemente ist von mehreren Faktoren abhängig, insbesondere der Art des verwendeten Substrat- und Elektrodenmaterials inklusive dessen Mikrostruktur und Textur, der Belastung, d.h. dem Spannungszustand in den Elektroden als Überlagerung von intrinsischer Spannung und SAW-Lastspannung, der Betriebstemperatur und den Umgebungsbedingungen (Umgebungsatmosphäre). Bei extrem großen Spannungsamplituden oder Temperaturgradienten kann durch Rissbildung auch das piezoelektrische (und oft zusätzlich pyroelektrische) Substrat zerstört werden.

Weiterhin ist aus der DE 11 2005 002 562 T5 eine Vorrichtung zur Erregung einer akustischen Oberflächenwelle bekannt, bei der Interdigitalwandler zwischen ein piezoelektrisches und nichtpiezoelektrisches Element angeordnet werden und Vorbelastungseinrichtungen einen Druck auf das piezoelektrische Element gegen das nichtpiezoelektrische Element mit Hilfe der Interdigitalwandler aufbringen, wodurch eine mechanische Kopplung zwischen piezoelektrischem Element und Interdigitalwandlern realisiert wird.

Aus der DE 102 06 369 A1 ist eine Elektrodenstruktur mit verbesserter Leistungsverträglichkeit und ein Verfahren zu ihrer Herstellung bekannt. Danach wird zwischen ein piezoelektrisches Substrat und die Elektrodenstruktur eine mechanisch stabile Anpassungsschicht angeordnet, die eine gute Haftung aufweisen soll und aus Materialien ausgeführt sein soll, die eine geringere Materialermüdung und eine höhere Bruch-Dehngrenze aufweisen, als Al oder Al-Legierungen der bisherigen Elektrodenstrukturen.

Ebenfalls ist aus der DE 10 2008 001 000 A1 ein Schichtsystem für Elektroden bekannt, welches aus einem piezoelektrischen Substrat mit darauf befindlichen oder im Substrat eingebetteten Streifenstrukturen aus einem Kompositmaterial besteht, wobei das Kompositmaterial aus einem metallischen Matrixmaterial mit einer Einlagerungsphase aus Kohlenstoffnanostrukturen besteht.

Aus US2004/233020A1, DE10320702, JP2005012736 und EP1467484A2 sind ebenfalls akustische Oberflächenwellenbauelemente bekannt.

Die Aufgabe der vorliegenden Erfindung ist es, ein akustisches Oberflächenwellenbauelement anzugeben, bei welchem die Degradation der IDT deutlich herabgesetzt ist und damit eine deutlich längere Lebensdauer des akustischen Oberflächenwellenbauelements erreicht wird, sowie ein einfaches und kostengünstiges Verfahren zur Herstellung solcher akustischer Oberflächenwellenbauelemente anzugeben.

Die Aufgabe wird durch die in den unabhängigen Ansprüchen angegebene Erfindung gelöst. Vorteilhafte Ausgestaltungen sind Gegenstand der Unteransprüche. Das erfindungsgemäße akustische Oberflächenwellenbauelement besteht mindestens aus einem piezoelektrischen Material, Interdigitalwandlern, einem nichtpiezoelektrischen Material und elektrischen Kontaktierungen, wobei die Interdigitalwandler mindestens kraft- und/oder formschlüssig mit dem nichtpiezoelektrischen Material verbunden sind und durch sie Oberflächenwellen im piezoelektrischen Material anregbar sind, und mindestens teilweise im Bereich der Apertur der Interdigitalwandler die Interdigitalwandler vom piezoelektrischen Material durch Realisierung eines Abstandes zwischen den Interdigitalwandlern und dem piezoelektrischen Material, der minimal durch die Rauheit der Oberflächen der Interdigitalwandler und des piezoelektrischen Materials und maximal durch einen Abstand von 1000 nm begrenzt ist, realisiert ist, durch den die Interdigitalwandler und das piezoelektrische Material mechanisch entkoppelt sind, wobei der Abstand durch Abstandshalter außerhalb der Apertur der Interdigitalwandler und/oder durch Entfernung von Opferschichten oder einer oder mehrerer anderer Schichten zur Erzeugung einer freien Oberfläche auf den Interdigitalwandlern oder zur Realisierung einer geringeren Schichtdicke zwischen den Interdigitalwandlern und dem piezoelektrischen Material realisiert ist.

Ebenfalls vorteilhafterweise ist das piezoelektrische Material ein flächiges Material, eine Platte, ein Wafer oder eine Schicht oder eine Beschichtung auf einer Unterlage. Weiterhin vorteilhafterweise sind die Interdigitalwandler vollständig form- und/oder kraftschlüssig mit dem nichtpiezoelektrischen Material verbunden.

Vorteilhaft ist es auch, wenn mindestens 50 % der Fläche, vorteilhafterweise die vollständige Fläche, der Interdigitalwandler im Bereich der Apertur der Interdigitalwandler vom piezoelektrischen Material mechanisch entkoppelt ist.

Ebenfalls vorteilhaft ist es, wenn im Bereich der Apertur das nichtpiezoelektrische Material zu mindestens 50 %, vorteilhafterweise vollständig, von dem piezoelektrischen Material mechanisch entkoppelt ist.

Und auch vorteilhaft ist es, wenn die mechanische Entkopplung einen Abstand zwischen den Interdigitalwandlern und dem piezoelektrischen Material realisiert, der vorteilhafterweise 1 nm bis 500 nm, noch vorteilhafterweise 10 bis 100 nm, beträgt.

Von Vorteil ist es auch, wenn die mechanische Entkopplung von piezoelektrischem Material und Interdigitalwandler und nichtpiezoelektrischem Material mindestens teilweise im Bereich der Apertur der Interdigitalwandler durch Einbettung der Interdigitalwandler mindestens teilweise im Bereich der Apertur in das nichtpiezoelektrische Material bis unterhalb der Oberfläche des nichtpiezoelektrischen Materiales realisiert ist.

Bei dem erfindungsgemäßen Verfahren zur Herstellung eines akustischen Oberflächenwellenbauelementes werden auf ein nichtpiezoelektrisches Material Interdigitalwandler aufgebracht und mit dem nichtpiezoelektrischen Material form- und/oder kraftschlüssig verbunden, die Interdigitalwandler elektrisch kontaktiert und nachfolgend das piezoelektrische Material, im Falle einer vollständigen Beabstandung von den Interdigitalwandlern mindestens teilweise in Kontakt mit mindestens dem nichtpiezoelektrischen Material gebracht und ein präziser Abstand, der minimal durch die Rauheit der Oberflächen der Interdigitalwandler und des piezoelektrischen Materials und maximal durch einen Abstand von 1000 nm begrenzt ist, zwischen den Interdigitalwandlern und dem piezoelektrischen Material eingestellt. Ebenfalls wird bei dem erfindungsgemäßen Verfahren zur Herstellung eines akustischen Oberflächenwellenbauelementes auf ein piezoelektrisches Material mindestens im Bereich der Apertur eine Opferschicht aufgebracht, danach eine Schicht zur Realisierung der Interdigitalwandler aufgebracht und strukturiert und danach eine nichtpiezoelektrische Schicht aufgebracht und strukturiert und danach die Opferschicht mindestens teilweise entfernt.

Vorteilhafterweise werden auf ein nichtpiezoelektrisches Material Interdigitalwandler mit Zwischenschichten und/oder Deckschichten aufgebracht.

Weiterhin vorteilhafterweise werden die Zwischenschicht oder Zwischenschichten mittels Atomlagenabscheidung (Atomic Layer Deposition), Gasphasensilanisierung, mittels Oxidation oder Nitrierung oder Karbidbildung und nachfolgender Wärmebehandlung der Interdigitalwandler in sauerstoffhaltiger oder stickstoffhaltiger oder kohlenstoffhaltiger Atmosphäre aufgebracht.

Ebenfalls vorteilhafterweise wird eine Opferschicht aufgebracht, die aus einem organischen Material (Fotolack) oder einem metallischem Material besteht.

Und auch vorteilhafterweise wird die Opferschicht mittels selektiven Trockenätzens oder nasschemischen Ätzens oder mittels Lösungsmittelbehandlung mindestens teilweise, vorzugsweise vollständig, entfernt.

Vorteilhaft ist es auch, wenn nichtpiezoelektrische Schichten aufgebracht werden, die aus SiO₂ oder Al₂O₃ oder Si₃N₄ bestehen.

Mit der erfindungsgemäßen Lösung ist es erstmals möglich akustische Oberflächenwellenbauelemente anzugeben, bei welchen die Degradation der Interdigitalwandler (IDT) deutlich herabgesetzt und die Lebensdauer der Bauelemente deutlich verlängert ist, ohne eine Optimierung der verwendeten Materialien vornehmen zu müssen. Dies wird im Wesentlichen erreicht, indem mindestens im Bereich der Apertur der IDT mindestens teilweise eine mechanische Entkopplung zwischen den IDT und dem piezoelektrischen Material realisiert wird.

Diese mechanische Entkopplung kann beispielsweise durch Realisierung eines Abstandes zwischen den IDT und dem piezoelektrischen Material mindestens im Bereich der Apertur der IDT erreicht werden.

Ein solcher Abstand kann beispielsweise durch Aufbringen von einer oder mehreren Schichten zwischen IDT und piezoelektrischem Material realisiert werden, wobei diese Schicht oder Schichten zur Herstellung des Abstands nur außerhalb des Bereiches der Apertur aufgebracht werden. Diese Schichten dienen dabei als Abstandshalter außerhalb der Apertur der IDT.

Ebenso kann auch diese Schicht oder können diese Schichten im Bereich der Apertur entweder mit geringeren Schichtdicken aufgebracht werden oder die Schicht oder Schichten werden in diesem Bereich ganz oder teilweise am Ende des Prozesses wieder entfernt.

Weiterhin kann der Abstand auch dadurch realisiert werden, dass die IDT in ein nichtpiezoelektrisches Material formschlüssig und unter Beibehaltung mindestens einer freien Oberfläche eingebettet werden, wobei die freie Oberfläche oder Oberflächen der IDT in der Vertiefung und unterhalb der Oberfläche des nichtpiezoelektrischen Materiales angeordnet wird. Damit bildet mindestens die Abstandsdifferenz, welche sich zwischen freier Oberfläche des IDT und Oberfläche des nichtpiezoelektrischen Materials ergibt, denjenigen Abstand, der die mechanische Entkopplung realisiert.

Zwingende Voraussetzung für das erfindungsgemäße akustische Oberflächenwellenbauelement ist, dass der Abstand zwischen IDT und piezoelektrischem Material nicht so groß ist, dass eine Anregung der akustischen Oberflächenwellen nicht mehr erreicht wird. Dies ist im Allgemeinen bei einem Abstand zwischen IDT und piezoelektrischem Material von mehr als 1000 nm der Fall, so dass größere Abstände nicht mehr zu einer sicheren Arbeitsweise des Bauelementes führen.

Die Degradation der IDT infolge Mikrorissbildung oder Loch- und Hügelbildung in SAW-Bauelementen bei hohen HF-Leistungen und folglich hohen SAW-Amplituden wird erfindungsgemäß dadurch deutlich verringert, dass der starre mechanische Verbund zwischen den IDT und dem piezoelektrischen Material aufgelöst wird und so die Übertragung der lokalen zeitabhängigen mechanischen Dehnung der Oberfläche des piezoelektrischen Materials auf die IDT unterdrückt oder vollständig verhindert wird.

Eine sichere Funktion als SAW-Bauelement wird bei mechanischer Entkopplung zwischen IDT und piezoelektrischer Materialoberfläche erfindungsgemäß durch das kapazitive Einkoppeln des elektrischen HF-Signals von den mechanisch entkoppelten IDT einerseits und durch die zeitliche Stabilität (auch während des Betriebs) der geometrischen und mechanischen Eigenschaften des IDT andererseits gewährleistet. Der minimale Abstand zwischen den IDT und dem piezoelektrischen Material kann erfindungsgemäß durch die Rauheit der Oberflächen von IDT und piezoelektrischem Material bestimmt werden, wobei in diesem Fall der IDT zumindest teilweise in direktem elektrischen Kontakt zum piezoelektrischen Material steht. Er beträgt vorteilhafterweise aber 1 nm bis mehrere 10 nm, jedoch maximal 1000 nm. In jedem Fall soll eine maximale mechanische Entkopplung zwischen IDT und piezoelektrischem Material einerseits und eine maximale Einkopplung des elektrischen Feldes in das piezoelektrische Material ohne Degradation des Materials der IDT andererseits erreicht werden, so dass die gewünschte Frequenzcharakteristik trotz des Abstandes zwischen IDT und piezoelektrischem Material bestmöglich angeregt werden kann.

Das piezoelektrische Material ist vorteilhafterweise ein flächiges Material, eine Platte, ein Wafer oder eine Schicht oder eine Beschichtung auf einer Unterlage. Dies kann beispielsweise ein Einkristallwafer oder eine einkristalline Schicht sein, die auf einem nichtpiezoelektrischen Material abgeschieden werden kann, oder es kann ein polykristallines, piezoelektrisches Schichtmaterial auf einem nichtpiezoelektrischen Material sein.

Als piezoelektrische und nichtpiezoelektrische Materialien sowie als Materialien für die IDT oder für die Kontaktierungen können alle Materialien eingesetzt werden, die nach dem Stand der Technik für derartige akustische Oberflächenwellenbauelemente bekannt sind, wie z.B. LiNbO₃, LiTaO₃, Quarz, AlN, Al, Au, Cu, Pt, Ru u.a.

Für die Realisierung der mechanischen Entkopplung zwischen IDT und piezoelektrischem Material bestehen mehrere Möglichkeiten.

Erfindungsgemäß können dazu die IDT auf ein nichtpiezoelektrisches, elektrisch isolierendes oder elektrisch gering leitfähiges (z.B. halbleitendes) Material aufgebracht und dieses mit derjenigen Oberfläche, auf welcher die IDT angeordnet sind, auf die Oberfläche des piezoelektrischen Materials aufgelegt werden. Die Fixierung des nichtpiezoelektrischen Materials mit den IDT auf dem piezoelektrischen Material kann über chemisch-physikalische Kräfte, z.B. durch Waferbonden, realisiert werden, wobei haftvermittelnde Zwischen- und Deckschichten, wie z.B. SiO₂, Klebstoffe, Fotolacke, Metallschichten usw. zum Einsatz kommen können. In diesem Fall wird der Abstand zwischen den IDT und dem piezoelektrischen Material durch die Rauheit der Oberflächen von IDT und diesem Material bestimmt, wobei im Falle des Vorhandenseins von haftvermittelnden Zwischen- und Deckschichten diese berücksichtigt werden müssen.

Es ist aber auch möglich, zur Einstellung eines Abstandes zwischen IDT und piezoelektrischem Material separate Abstandselemente vorteilhafterweise aus strukturierten Dünnschichten einzufügen, die vorzugsweise außerhalb der Apertur der IDT angeordnet sind und mittels Planartechnik aufgebracht werden können, wodurch eine präzise Einstellung des Abstandes zwischen den IDT und dem piezoelektrischen Material bis in den Sub-nm-Bereich möglich ist.

Ebenso ist es möglich, dass zwischen die IDT und das piezoelektrische Material eine oder mehrere Schichten aufgebracht werden, die mindestens im Bereich der Apertur eine geringere Schichtdicke als außerhalb der Apertur aufweisen und dadurch den Abstand zur mechanischen Entkopplung realisieren.

Weiterhin ist es möglich, Opferschichten, wie z.B. Fotolack oder Metallschichten, zwischen dem piezoelektrischen Material und den IDT, vorzugsweise innerhalb der Apertur, anzuordnen, die im Verlaufe des technologischen Herstellungsprozesses wieder entfernt werden. Die mechanische Fixierung der IDT kann durch eine mechanisch stabile und elektrisch isolierende Deckschicht, z.B. aus SiOₓ, Si₃N₄, Al₂O₃, erfolgen. Durch anschließendes, selektives Herauslösen der Opferschicht wird zwischen den IDT und dem piezoelektrischen Material ein Abstand erzeugt. Weiterhin kann es vorteilhaft sein, die Abmessungen der Opferschicht in Richtung der akustischen Wellenausbreitung über die IDT-Abmessungen hinaus zu erweitern.

Dabei ist eine gute Haftung dieser Schicht oder Schichten zum piezoelektrischen Material und zum Material der IDT vorteilhaft, aber in Verbindung mit einer mechanisch stabilen und elektrisch isolierenden Deckschicht nicht zwingend erforderlich.

Nachfolgend wird die Erfindung an mehreren Ausführungsbeispielen näher erläutert.

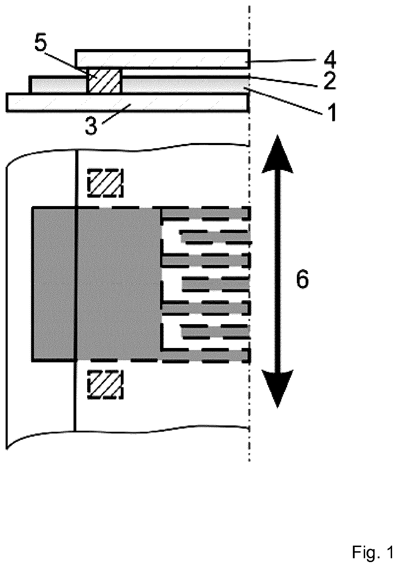

Dabei zeigen
- Fig. 1: eine prinzipielle Darstellung der mechanischen Entkopplung von IDT und piezoelektrischem Material mittels separater Abstandshalter außerhalb der Apertur

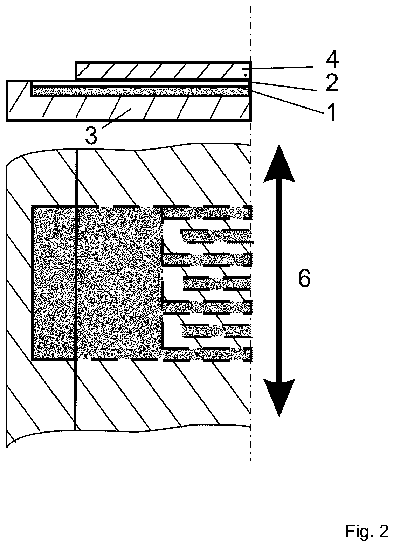

- Fig. 2: eine prinzipielle Darstellung der mechanischen Entkopplung von IDT und durch Einbetten der IDT in das nichtpiezoelektrische Material, wobei die Oberfläche der IDT unterhalb der Oberfläche des nichtpiezoelektrischen Materials liegt

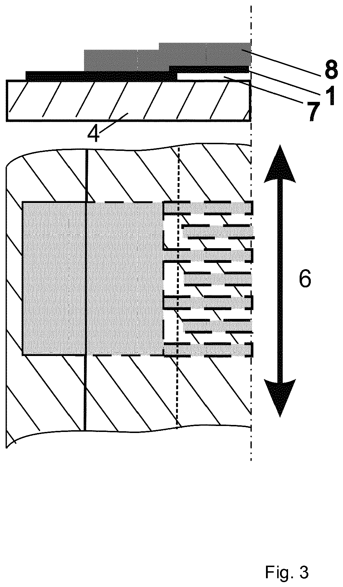

- Fig. 3: eine prinzipielle Darstellung der mechanischen Entkopplung von IDT und piezoelektrischem Material mittels einer vor der Strukturierung der IDT im Bereich der Apertur auf das piezoelektrische Material aufgebrachten Opferschicht, welche nach der Strukturierung des IDT und dessen Stabilisierung durch Aufbringen einer nichtpiezoelektrischen isolierenden Schicht wieder entfernt wird.

### Beispiel 1

Das Beispiel betrifft die Herstellung eines akustischen Oberflächenwellenbauelements in Form einer Verzögerungsstrecke aus zwei in einem Abstand von 0.5 mm angeordneten IDT.

Eine 400 nm dicke Schicht aus einer Al(Cu)-Legierung mit einer 5 nm dicken Ti-Schicht werden auf einem nichtpiezoelektrischen Material 3 ((100)Si-Wafer mit einer amorphen und elektrisch isolierenden 3 µm dicken SiO₂-Schicht darauf) und darauf einer Lackmaske für zwei gleichartige IDT (je 0.25 mm x 1 mm, 0.2 mm Apertur) und den zugehörigen Kontaktflächen (1 mm x 1 mm), die im Abstand von 0.5 mm zueinander angeordnet sind, mittels Elektronenstrahlverdampfens abgeschieden. Nachfolgend wird mittels Lift-Off-Technik die Lackmaske mit der darauf befindlichen Metallschicht entfernt, so dass zwei strukturierte IDT mit Kontaktflächen 1 vorliegen. Anschließend wird mit Hilfe eines ALD-Prozesses eine 5 nm dicke Al₂O₃-Schicht als Deckschicht 2 ganzflächig abgeschieden. Danach wird eine weitere Lackmaske für die Abstandshalter 5 aufgebracht und eine weitere Al(Cu)-Schicht (gleiches Schichtmaterial wie bei den IDT mit Kontaktflächen 1) abgeschieden, deren Dicke um 10 nm die Dicke der IDT mit Kontaktflächen 1 (405 nm) übersteigt, und über die Lift-Off-Technik prozessiert. Die so erzeugten Abstandhalter 5 haben einen lateralen Abstand zur Apertur der IDT mit Kontaktflächen 1 von 10 µm in Richtung der Längsachse der Finger und Abmessungen von 10 µm x 10 µm. Sie sind direkt seitlich neben den IDT mit Kontaktflächen 1 in einem Abstand von 10 µm angeordnet. Die Höhe der Abstandshalter 5 beträgt somit 415 nm. Nach dieser Prozessierung wird ein piezoelektrisches Material 4 in Form einer ebenen Platte aus einem doppelseitig polierten piezoelektrischen LiNbO₃-Einkristallwafermaterial aufgebracht, wobei die Abmessungen des plattenförmigen piezoelektrischen Materials 4 so gewählt sind, dass das plattenförmige piezoelektrische Material 4 die Abstandshalter 5 überdeckt, die Kontaktflächen des IDT mit Kontaktflächen 1 jedoch über die seitlichen Abmessungen des piezoelektrischen Materials 4 um 0.2 mm hinausragen und das piezoelektrische Material 4 über beide IDT mit Kontaktfläche 1 um je 100 µm hinausragt. In diesem Beispiel betragen die Abmessungen des plattenförmigen piezoelektrischen Materials 4 folglich 1.25 mm quer zur Ausbreitungsrichtung und 2.7 mm in Ausbreitungsrichtung der akustischen Welle. Die nicht überdeckten Kontaktflächen beider IDT mit Kontaktflächen 1 betragen 0.5 mm x 1 mm. Die Abstandshalter 5 stehen somit im direkten Kontakt mit einer der polierten Oberflächen des piezoelektrischen Materials 4. Die Kontaktierung der IDT mit Kontaktflächen 1 erfolgt über die, seitlich über das piezoelektrische Material 4 hinausragenden, Kontaktflächen mittels Drahtbondens. Somit ist im Bereich der Apertur ein Abstand zwischen den IDT mit Kontaktflächen 1 und dem piezoelektrischen Material 4 von 10 nm und damit eine mechanische Entkopplung realisiert.

Die Degradation des Materials des IDT mit Kontaktflächen 1 ist in diesem Beispiel, verglichen mit bezüglich des piezoelektrischen Materials mechanisch nicht entkoppelten IDT, um den Faktor 6 herabgesetzt. Damit weist das Oberflächenwellenbauelement eine deutlich längere Lebensdauer auf.

### Beispiel 2

Das Beispiel betrifft die Herstellung eines akustischen Oberflächenwellenbauelements in Form einer Verzögerungsstrecke aus zwei in einem Abstand von 0.5 mm angeordneten IDT.

An der Oberfläche eines nichtpiezoelektrisches Material 3 ((100)Si-Wafer mit einer durch thermische Oxidation hergestellten Siliziumdioxidschicht mit einer Dicke von 3 µm) werden Gräben mithilfe des reaktiven Ionenätzens (Reactive Ion Etching, RIE) in der lateralen Geometrie der zu realisierenden Interdigitalwandler mit Kontaktflächen 1 (je 0.25 mm x 1 mm, 0.2 mm Apertur) und den zugehörigen Kontaktflächen (1 mm x 1 mm), die im Abstand von 0.5 mm zueinander angeordnet sind, und einer Tiefe von 600 nm geätzt. Danach werden jeweils mittels Magnetronsputterns eine 10 nm dicke Ta-Si-N Diffusionsbarriereschicht und darauf eine 50 nm dicke Keimschicht aus Kupfer aufgebracht, und dann durch Elektroplating eine 1 µm dicke Cu-Schicht unter Verwendung eines Cu-haltigen Elektrolyten abgeschieden. Anschließend wird das Kupfer zwischen den Gräben mittels chemisch-mechanischen Polierens (Cu-Slurry 1) zunächst bis zur Ta-Si-N-Oberfläche abpoliert. Mit einem daran anschließenden Polierschritt (Slurry 2) wird die Ta-Si-N-Schicht vollständig sowie die SiO₂-Schichtdicke und die Cu-Schichtdicke teilweise in den Fingerzwischenräumen der IDT mit Kontaktflächen 1 vorwiegend mechanisch-abrasiv soweit abgetragen, bis die Cu-Gesamtschichtdicke 410 nm beträgt. Im Folgenden wird dann durch selektives nasschemisches Ätzen nur das Cu um weitere 10 nm abgedünnt, sodass die IDT mit Kontaktflächen 1 um diese 10 nm tiefer liegen im Vergleich zur Oberfläche des nichtpiezoelektrischen Materials 3. Auf die Oberfläche des nichtpiezoelektrischen Materials 3 wird dann ein piezoelektrisches Material 4 in Form einer dünnen polierten Platte (LiNbO₃-Einkristallwafer) in den Abmessungen 1.25 mm x 2.7 mm x 0.18 mm) mit der polierten Seite auf das nichtpiezoelektrische Material 3 aufgelegt und mittels Waferbondens fest miteinander verbunden. Der Abstand zwischen den IDT mit Kontaktflächen 1 in den Gräben des nichtpiezoelektrischen Materials 3 und der Oberfläche des piezoelektrischen Materials 4 beträgt nunmehr 10 nm und realisiert die mechanische Entkopplung. Die Degradation des Materials des IDT mit Kontaktflächen 1 ist in diesem Beispiel, verglichen mit bezüglich des piezoelektrischen Materials mechanisch nicht entkoppelten IDT, um den Faktor 5 herabgesetzt. Damit weist das Oberflächenwellenbauelement eine deutlich längere Lebensdauer auf.

### Beispiel 3

Das Beispiel betrifft die Herstellung eines akustischen Oberflächenwellenbauelements in Form eines Aktors aus einem bidirektional abstrahlenden IDT.

Auf einem piezoelektrisches Material 4 (LiNbO₃-Einkristallwafer) wird eine 100 nm dicke Schicht (Opferschicht 7) aus SU-8 Fotolack aufgeschleudert und fotolithografisch so strukturiert, dass nur der Bereich von 3 mm x 0.25 mm zwischen den Kontaktflächen des IDT mit Kontaktflächen 1 (Abmessungen (2.25 mm x 1mm, 0.2 mm Apertur), d.h. der Bereich der Apertur von 0.2 mm und der Bereich von je 0,025 µm der nichtüberlappenden Fingerelektroden an jeder Seite in Richtung der Kontaktflächen mit der Opferschicht 7 bedeckt sind. In SAW-Ausbreitungsrichtung ist die Schicht folglich nach beiden Seiten des IDT mit Kontaktflächen 1 jeweils um 1 mm breiter als der IDT mit Kontaktflächen 1. Danach wird eine Lackmaske für den IDT mit Kontaktflächen 1 aufgebracht und anschließend eine 5 nm dicke Ti sowie eine 350 nm dicke Al-Schicht mittels Elektronenstrahlverdampfung abgeschieden. Durch einen anschließenden Lift-Off-Prozess wird daraus der IDT mit Kontaktflächen 1 strukturiert. Im Anschluss daran wird eine 2 µm dicke nichtpiezoelektrische Schicht 8 (SiOₓ) zur mechanischen Stabilisierung des IDT mit Kontaktflächen 1 aufgesputtert (Magnetronsputtern bei T<95°C), die einen E-Modul > 72 GPa hat. In diese nichtpiezoelektrische Schicht 8 werden durch selektives nasschemisches Ätzen rechteckförmige Aussparungen in den Abmessungen 0.25 µm x 0.25 µm an jeder Seite des IDT des IDT mit Kontaktflächen 1 erzeugt. Über einen nasschemischen Prozessschritt wird mit einem organischen Lösungsmittel (SU-8 Entwickler) die Opferschicht 7 herausgelöst, wodurch eine mechanische Entkopplung von piezoelektrischem Material 4 und IDT mit Kontaktflächen 1 sowie piezoelektrischem Material 4 und nichtpiezoelektrischer Schicht 8 im Bereich des IDT mit Kontaktflächen 1 erfolgt. Die mechanische Stabilität (Formstabilität) des IDT mit Kontaktflächen 1 wird durch die form- und kraftschlüssige Verbindung von IDT und nichtpiezoelektrischer Schicht 8 erreicht.

Die Degradation des Materials des IDT mit Kontaktflächen 1 ist in diesem Beispiel, verglichen mit bezüglich des piezoelektrischen Materials mechanisch nicht entkoppelten IDT, um den Faktor 7 herabgesetzt. Damit weist das Oberflächenwellenbauelement eine deutlich längere Lebensdauer auf.

### Bezugszeichenliste

1: Interdigitalwandler mit Kontaktflächen
2: Deckschicht
3: Nichtpiezoelektrisches Material
4: Piezoelektrisches Material
5: Abstandshalter
6: Dominante SAW-Ausbreitungsrichtung
7: Opferschicht oder Leerraum nach deren Herauslösen
8: Nichtpiezoelektrische Schicht

## Patentansprüche

1. Akustisches Oberflächenwellenbauelement, bestehend mindestens aus einem piezoelektrischen Material, Interdigitalwandlern, einem nichtpiezoelektrischen Material und elektrischen Kontaktierungen, wobei die Interdigitalwandler mindestens kraft- und/oder formschlüssig mit dem nichtpiezoelektrischen Material verbunden sind und durch sie Oberflächenwellen im piezoelektrischen Material anregbar sind, und mindestens teilweise im Bereich der Apertur der Interdigitalwandler durch Realisierung eines Abstandes zwischen den Interdigitalwandlern und dem piezoelektrischen Material, der minimal durch die Rauheit der Oberflächen der Interdigitalwandler und des piezoelektrischen Materials und maximal durch einen Abstand von 1000 nm begrenzt ist, realisiert ist, durch den die Interdigitalwandler und das piezoelektrische Material mechanisch entkoppelt sind, wobei der Abstand durch Abstandshalter außerhalb der Apertur der Interdigitalwandler und/oder durch Entfernung von Opferschichten oder einer oder mehrerer anderer Schichten zur Erzeugung einer freien Oberfläche auf den Interdigitalwandlern oder zur Realisierung einer geringeren Schichtdicke zwischen den Interdigitalwandlern und dem piezoelektrischen Material realisiert ist.

2. Akustisches Oberflächenwellenbauelement nach Anspruch 1, bei dem das piezoelektrische Material ein flächiges Material, eine Platte, ein Wafer oder eine Schicht oder eine Beschichtung auf einer Unterlage ist.

3. Akustisches Oberflächenwellenbauelement nach Anspruch 1, bei dem die Interdigitalwandler vollständig form- und/oder kraftschlüssig mit dem nichtpiezoelektrischen Material verbunden sind.

4. Akustisches Oberflächenwellenbauelement nach Anspruch 1, bei dem mindestens 50 % der Fläche, vorteilhafterweise die vollständige Fläche, der Interdigitalwandler im Bereich der Apertur der Interdigitalwandler vom piezoelektrischen Material mechanisch entkoppelt ist, und/oder bei dem im Bereich der Apertur das nichtpiezoelektrische Material zu mindestens 50 %, vorteilhafterweise vollständig, von dem piezoelektrischen Material mechanisch entkoppelt ist.

5. Akustisches Oberflächenwellenbauelement nach Anspruch 1, bei dem die mechanische Entkopplung einen Abstand zwischen den Interdigitalwandlern und dem piezoelektrischen Material realisiert, der vorteilhafterweise 1 nm bis 500 nm, noch vorteilhafterweise 10 bis 100 nm, beträgt.

6. Akustisches Oberflächenwellenbauelement nach Anspruch 1, bei dem die mechanische Entkopplung von piezoelektrischem Material und Interdigitalwandler und nichtpiezoelektrischem Material mindestens teilweise im Bereich der Apertur der Interdigitalwandler durch Einbettung der Interdigitalwandler mindestens teilweise im Bereich der Apertur in das nichtpiezoelektrische Material bis unterhalb der Oberfläche des nichtpiezoelektrischen Materiales realisiert ist.

7. Verfahren zur Herstellung eines akustischen Oberflächenwellenbauelementes gemäß Anspruch 1, bei dem auf ein nichtpiezoelektrisches Material Interdigitalwandler aufgebracht und mit dem nichtpiezoelektrischen Material form- und/oder kraftschlüssig verbunden werden, die Interdigitalwandler elektrisch kontaktiert werden und nachfolgend das piezoelektrische Material, im Falle einer vollständigen Beabstandung von den Interdigitalwandlern mindestens teilweise in Kontakt mit mindestens dem nichtpiezoelektrischen Material gebracht wird und ein präziser Abstand, der minimal durch die Rauheit der Oberflächen der Interdigitalwandler und des piezoelektrischen Materials und maximal durch einen Abstand von 1000 nm begrenzt ist, zwischen den Interdigitalwandlern und dem piezoelektrischen Material eingestellt wird.

8. Verfahren zur Herstellung eines akustischen Oberflächenwellenbauelementes gemäß Anspruch 1, bei dem auf ein piezoelektrisches Material mindestens im Bereich der Apertur eine Opferschicht aufgebracht wird, danach eine Schicht zur Realisierung der Interdigitalwandler aufgebracht und strukturiert wird und danach eine nichtpiezoelektrische Schicht aufgebracht und strukturiert wird und danach die Opferschicht mindestens teilweise entfernt wird.

9. Verfahren zur Herstellung eines akustischen Oberflächenwellenbauelements nach Anspruch 7 oder 8, bei dem auf ein nichtpiezoelektrisches Material Interdigitalwandler mit Zwischenschichten und/oder Deckschichten aufgebracht werden.

10. Verfahren nach Anspruch 9, bei dem die Zwischenschicht oder Zwischenschichten mittels Atomlagenabscheidung (Atomic Layer Deposition), Gasphasensilanisierung, mittels Oxidation oder Nitrierung oder Karbidbildung und nachfolgender Wärmebehandlung der Interdigitalwandler in sauerstoffhaltiger oder stickstoffhaltiger oder kohlenstoffhaltiger Atmosphäre aufgebracht werden.

11. Verfahren nach Anspruch 8, bei dem eine Opferschicht aufgebracht wird, die aus einem organischen Material (Fotolack) oder einem metallischen Material besteht, und/oder bei dem die Opferschicht mittels selektiven Trockenätzens oder nasschemischen Ätzens oder mittels Lösungsmittelbehandlung mindestens teilweise, vorzugsweise vollständig, entfernt wird.

12. Verfahren nach Anspruch 7 oder 8, bei dem nichtpiezoelektrische Schichten aufgebracht werden, die aus SiO₂ oder Al₂O₃ oder Si₃N₄ bestehen.

## Claims

1. Surface acoustic wave component, consisting at least of a piezoelectric material, interdigital transducers, a non-piezoelectric material and electrical contact-connections, wherein the interdigital transducers are connected to the non-piezoelectric material at least in a force-locking and/or a positively locking manner and they can excite surface waves in the piezoelectric material, and, at least partly in the region of the aperture of the interdigital transducers, by means of the realisation of a spacing between the interdigital transducers and the piezoelectric material, which spacing is delimited minimally by the roughness of the surfaces of the interdigital transducers and of the piezoelectric material and maximally by a spacing of 1,000 nm, is realised, by means of which the interdigital transducers and the piezoelectric material are mechanically decoupled, wherein the spacing is realised by spacers outside the aperture of the interdigital transducers and/or by the removal of sacrificial layers or of one or more other layers in order to produce a free surface on the interdigital transducers or in order to realise a smaller layer thickness between the interdigital transducers and the piezoelectric material.

2. Surface acoustic wave component according to Claim 1, wherein the piezoelectric material is a planar material, a plate, a wafer or a layer or a coating on a support.

3. Surface acoustic wave component according to Claim 1, wherein the interdigital transducers are connected to the non-piezoelectric material completely in a positively locking and/or a force-locking manner.

4. Surface acoustic wave component according to Claim 1, wherein at least 50% of the area, advantageously the complete area, of the interdigital transducers in the region of the aperture of the interdigital transducers is mechanically decoupled from the piezoelectric material, and/or wherein, in the region of the aperture, the non-piezoelectric material is mechanically decoupled from the piezoelectric material to the extent of at least 50%, advantageously completely.

5. Surface acoustic wave component according to Claim 1, wherein the mechanical decoupling realises a spacing between the interdigital transducers and the piezoelectric material, which spacing is advantageously 1 nm to 500 nm, additionally advantageously 10 to 100 nm.

6. Surface acoustic wave component according to Claim 1, wherein the mechanical decoupling of piezoelectric material and interdigital transducer and non-piezoelectric material at least partly in the region of the aperture of the interdigital transducers is realised by means of the embedding of the interdigital transducers at least partly in the region of the aperture into the non-piezoelectric material as far as below the surface of the non-piezoelectric material.

7. Method for producing a surface acoustic wave component according to Claim 1, wherein interdigital transducers are applied to a non-piezoelectric material and are connected to the non-piezoelectric material in a positively locking and/or a force-locking manner, the interdigital transducers are electrically contact-connected and subsequently the piezoelectric material, in the case of complete spacing apart from the interdigital transducers, is at least partly brought into contact with at least the non-piezoelectric material and a precise spacing, which is delimited minimally by the roughness of the surfaces of the interdigital transducers and of the piezoelectric material and maximally by a spacing of 1,000 nm, between the interdigital transducers and the piezoelectric material is set.

8. Method for producing a surface acoustic wave component according to Claim 1, wherein a sacrificial layer is applied to a piezoelectric material at least in the region of the aperture, then a layer for realising the interdigital transducers is applied and structured and then a non-piezoelectric layer is applied and structured and then the sacrificial layer is at least partly removed.

9. Method for producing a surface acoustic wave component according to Claim 7 or 8, wherein interdigital transducers with intermediate layers and/or cover layers are applied to a non-piezoelectric material.

10. Method according to Claim 9, wherein the intermediate layer or intermediate layers is or are applied by means of atomic layer deposition, vapour phase silanisation, by means of oxidation or nitriding or carbide formation and subsequent heat treatment of the interdigital transducers in an oxygen-containing or nitrogen-containing or carbon-containing atmosphere.

11. Method according to Claim 8, wherein a sacrificial layer is applied which consists of an organic material (photoresist) or a metallic layer, and/or wherein the sacrificial layer is removed at least partly, preferably completely, by means of selective dry etching or wet-chemical etching or by means of solvent treatment.

12. Method according to Claim 7 or 8, wherein non-piezoelectric layers consisting of SiO₂ or Al₂O₃ or Si₃N₄ are applied.

## Revendications

1. Composant à ondes de surface acoustiques, constitué au moins d'un matériau piézoélectrique, de convertisseurs interdigitaux, d'un matériau non piézoélectrique et d'éléments de mise en contact électriques, les convertisseurs interdigitaux étant reliés au moins par assemblage de force et/ou par complémentarité de formes avec le matériau non piézoélectrique et des ondes de surface pouvant être excitées par ceux-ci dans le matériau piézoélectrique, et est réalisé au moins partiellement dans la zone de l'ouverture des convertisseurs interdigitaux par la réalisation d'un écart entre les convertisseurs interdigitaux et le matériau piézoélectrique, lequel est délimité au minimum par la rugosité de la surface des convertisseurs interdigitaux et du matériau piézoélectrique et au maximum par un écart de 1000 nm, par lequel les convertisseurs interdigitaux et le matériau piézoélectrique sont découplés mécaniquement, l'écart étant réalisé par des entretoises à l'extérieur de l'ouverture des convertisseurs interdigitaux et/ou par l'enlèvement de couches sacrificielles ou d'un ou plusieurs autres couches en vue de produire une surface livre sur les convertisseurs interdigitaux ou en vue de réaliser une épaisseur de couche plus faible entre les convertisseurs interdigitaux et le matériau piézoélectrique.

2. Composant à ondes de surface acoustiques selon la revendication 1, avec lequel le matériau piézoélectrique est un matériau plat, une plaque, une galette ou une couche ou un revêtement sur un substrat.

3. Composant à ondes de surface acoustiques selon la revendication 1, avec lequel les convertisseurs interdigitaux sont entièrement reliés au matériau non piézoélectrique par complémentarité de formes et/ou par assemblage de force.

4. Composant à ondes de surface acoustiques selon la revendication 1, avec lequel au moins 50 % de la surface, avantageusement la surface complète, des convertisseurs interdigitaux sont découplés mécaniquement du matériau piézoélectrique dans la zone de l'ouverture des convertisseurs interdigitaux et/ou avec lequel, dans la zone de l'ouverture, le matériau non piézoélectrique est découplé mécaniquement sur au moins 50 %, de préférence entièrement, du matériau piézoélectrique.

5. Composant à ondes de surface acoustiques selon la revendication 1, avec lequel le découplage mécanique réalise un écart entre les convertisseurs interdigitaux et le matériau piézoélectrique, lequel est avantageusement de 1 nm à 500 nm, plus avantageusement de 10 nm à 100 nm.

6. Composant à ondes de surface acoustiques selon la revendication 1, avec lequel le découplage mécanique des convertisseurs interdigitaux du matériau piézoélectrique et du matériau non piézoélectrique est réalisé au moins partiellement dans la zone de l'ouverture des convertisseurs interdigitaux par enrobage des convertisseurs interdigitaux au moins partiellement dans la zone de l'ouverture dans le matériau non piézoélectrique jusqu'au-dessous de la surface du matériau non piézoélectrique.

7. Procédé de fabrication d'un composant à ondes de surface acoustiques selon la revendication 1, avec lequel des convertisseurs interdigitaux sont appliqués sur un matériau non piézoélectrique et sont reliés par complémentarité de formes et/ou assemblage de force avec le matériau non piézoélectrique, le contact électrique est établi avec les convertisseurs interdigitaux et ensuite le matériau piézoélectrique, dans le cas d'un espacement complet des convertisseurs interdigitaux, est amené au moins partiellement en contact avec au moins le matériau non piézoélectrique et un écart précis, lequel est délimité au minimum par la rugosité de la surface des convertisseurs interdigitaux et du matériau piézoélectrique et au maximum par un écart de 1000 nm, est réglé entre les convertisseurs interdigitaux et le matériau piézoélectrique.

8. Procédé de fabrication d'un composant à ondes de surface acoustiques selon la revendication 1, avec lequel une couche sacrificielle est appliquée sur un matériau piézoélectrique au moins dans la zone de l'ouverture, une couche destinée à la réalisation des convertisseurs interdigitaux est appliquée et structurée et ensuite une couche de matériau non piézoélectrique est appliquée et structurée et ensuite la couche sacrificielle est au moins partiellement retirée

9. Procédé de fabrication d'un composant à ondes de surface acoustiques selon la revendication 7 ou 8, avec lequel des convertisseurs interdigitaux comprenant des couches intermédiaires et/ou des couches de recouvrement sont appliqués sur un matériau non piézoélectrique.

10. Procédé selon la revendication 9, avec lequel la couche intermédiaire ou les couches intermédiaires sont appliquées au moyen de dépôt de couches minces atomiques (Atomic Layer Deposition), silanisation en phase gazeuse, au moyen de l'oxydation ou de la nitruration ou formation de carbure et ensuite traitement thermique des convertisseurs interdigitaux dans une atmosphère oxygénée ou azotée ou carbonée.

11. Procédé selon la revendication 8, avec lequel la couche sacrificielle se compose d'un matériau organique (vernis photosensible) ou d'un matériau métallique et/ou avec lequel la couche sacrificielle est enlevée au moins partiellement, de préférence entièrement, au moyen d'une gravure à sec sélective ou d'une gravure chimique humide ou au moyen d'un traitement au solvant.

12. Procédé selon la revendication 7 ou 8, avec lequel sont appliquées des couches non piézoélectriques qui se composent de SiO₂ ou d'Al₂O₃ ou de Si₃N₄.
